# EUROPÄISCHE PATENTSCHRIFT

(11) **EP 2 452 359 B1**
(45) Veröffentlichungstag und Bekanntmachung des Hinweises auf die Patenterteilung: **27.06.2018**
(21) Anmeldenummer: 10728257.6
(22) Anmeldetag: 06.07.2010
(51) Int. Cl.: H01L 23/498, H01L 23/538, H01L 21/68

(54) **VERFAHREN ZUM HERSTELLEN EINER INTEGRIERTEN SCHALTUNG UND RESULTIERENDER FOLIENCHIP**
METHOD FOR PRODUCING AN INTEGRATED CIRCUIT AND RESULTING FOIL CHIP
PROCÉDÉ DE FABRICATION D UN CIRCUIT INTÉGRÉ ET PUCE SUR FILM EN RÉSULTANT

(30) Priorität: 06.07.2009 DE 102009032219
(43) Veröffentlichungstag der Anmeldung: 16.05.2012
(73) Patentinhaber: Institut Für Mikroelektronik Stuttgart, 70569 Stuttgart (DE)
(72) Erfinder: BURGHARTZ, Joachim, 70771 Leinfelden-Echterdingen (DE); HARENDT, Christine, 75417 Muehlacker (DE)
(74) Vertreter: Witte, Weller & Partner Patentanwälte mbB
(86) Internationale Anmeldenummer: PCT/EP2010/059647
(87) Internationale Veröffentlichungsnummer: WO 2011/003910

(56) Entgegenhaltungen:
- WO-A2-2005/048302
- DE-A1-102008 022 733
- US-A- 5 353 195
- US-A- 5 465 217
- US-A1- 2004 195 686
- US-A1- 2007 117 274
- US-A1- 2008 036 093

## Beschreibung

Die vorliegende Erfindung betrifft ein Verfahren zum Herstellen einer integrierten Schaltung, das heißt einer Schaltung mit einer Anzahl von elektronischen Bauelementen, die in einem gemeinsamen Halbleiterkörper integriert sind. Etwas genauer betrifft die vorliegende Erfindung ein Verfahren, um einen so genannten Halbleiterchip, der bspw. in konventioneller Siliziumtechnologie gefertigt wurde, mit Bauelementen der organischen Elektronik zu kombinieren. Ein gattungsgemäßes Verfahren gemäß dem Oberbegriff von Anspruch 1 ist aus US 5,353,195 bekannt.

Es ist seit Langem bekannt, integrierte Schaltungen auf Basis von weitgehend starren Halbleitermaterialien herzustellen, die vorwiegend aus der Gruppe IV des Periodensystems stammen oder kombinierte Materialen aus den Gruppen II und V des Periodensystems sind. Bekannte Materialien sind insbesondere Silizium, Germanium, Galliumarsenid und andere. Mit Hilfe von modernen Lithografieprozessschritten lassen sich aus solchen Materialien extrem feine Strukturen in und auf einem starren Halbleitersubstrat erzeugen. Typischerweise beinhalten die Lithografieprozessschritte die Erzeugung von Maskenstrukturen auf dem Halbleitersubstrat mit Hilfe von Belichtungs- und Ätzschritten sowie das Ablagern und/oder Einbringen von Fremdmaterialien auf oder in das Halbleitersubstrat. Die Lithografieprozesstechnik ist allerdings sehr aufwändig und teuer, so dass sich die Herstellung von integrierten Schaltungen erst bei sehr großen Stückzahlen und hohen Integrationsdichten amortisiert. Gleichwohl hat die Herstellung von integrierten Schaltungen in starren Halbleitermaterialien mit Hilfe von Lithografieprozessschritten eine weite Verbreitung gefunden.

Daneben gibt es seit einiger Zeit Bestrebungen, so genannte organische Halbleitermaterialien zur Herstellung von elektronischen Schaltungen zu verwenden. Die elektronischen Bauelemente werden hier vorwiegend, aber nicht ausschließlich aus organischen Materialien und/oder auf Folien aus organischem Material erzeugt, insbesondere Polymerfolien. In der Regel werden die Schaltungsstrukturen auf solchen Folien mit Hilfe von relativ kostengünstigen Druckverfahren erzeugt, was wirtschaftliche Vorteile gegenüber der konventionellen Halbleitertechnologie verspricht, insbesondere wenn das Endprodukt großflächig sein soll wie bei grafischen Displays. Die Drucktechniken führen prinzipbedingt zu gröberen Strukturen im Vergleich zu den sehr feinen Strukturen, die sich mit den "klassischen" Lithografietechniken auf Silizium und anderen starren Halbleitermaterialien erzeugen lassen. Die beiden Technologien, das heißt die integrierte Halbleitertechnologie auf Basis von Silizium und anderen starren Halbleitermaterialien und die organische Elektronik mit Drucktechniken, sind in gewisser Weise komplementär in Bezug auf die Kosten einer Schaltung pro Fläche, den Integrationsgrad und die Leistungsfähigkeit der Schaltung.

Es ist daher wünschenswert, die Vorteile beider Technologien in einem hybriden Ansatz zu kombinieren. Dazu ist es erforderlich, eine integrierte Schaltung, die auf oder in einem starren Halbleitersubstrat angeordnet ist, mit einem organischen Trägermaterial zu verbinden, das in der Regel flexibel ist. Schwierigkeiten bereitet hier vor allem die elektrische Kontaktierung der filigranen Strukturen auf dem starren Halbleitersubstrat, da die Strukturen auf dem organischen Trägermaterial mit bekannten Drucktechniken nicht so fein realisiert werden können. Andererseits setzen konventionelle Lithografieprozesse starre Materialien voraus.

EP 0 452 506 B1 offenbart ein Verfahren zum Herstellen eines flexiblen Folienstücks, an dem eine integrierte Halbleiterschaltung angeordnet ist. Das flexible Folienstück ist in einem Ausführungsbeispiel eine Polymerfolie. Die Folie wird auf einer Seite mit einer elektrisch leitfähigen Struktur versehen, die im Bereich der Montagestelle für die integrierte Halbleiterschaltung zapfenartige Vorsprünge aufweist. Die Vorsprünge greifen durch die Folie hindurch und ragen auf der zweiten Folienseite über die Folie hinaus. Dort kontaktieren sie so genannte Bonding-Pads, das sind spezielle Kontaktflächen, die im Randbereich der integrierten Halbleiterschaltung ausgebildet sind. Die Halbleiterschaltung wird mit den Bonding-Pads auf die freien Enden der zapfenartigen Vorsprünge aufgesetzt und verlötet. EP 0 452 506 B1 offenbart damit ein Verfahren, um einen weitgehend starren Halbleiterchip an einem flexiblen Folienstück mechanisch zu befestigen und elektrisch zu kontaktieren. Das bekannte Verfahren benötigt allerdings relativ große Kontaktflächen an dem Halbleiterchip, das heißt Kontaktflächen, die wesentlich größer sind als die Schaltungsstrukturen der einzelnen Bauelemente in dem Chip. Damit geht wertvolle Chipfläche für die Herstellung der integrierten Schaltungsstrukturen verloren. Je kleiner man die Kontaktflächen realisiert, desto höher ist der Aufwand beim Positionieren des Halbleiterchips auf den zapfenartigen Vorsprüngen. Diese Nachteile wirken sich besonders stark aus, wenn der Halbleiterchip mit der integrierten Schaltung bspw. eine Ansteuer- oder Treiberschaltung für ein großflächiges Display ist, das mit Hilfe der organischen Elektronik auf dem flexiblen Folienstück realisiert werden soll. Für eine solche Ansteuer- oder Treiberschaltung wird eine sehr große Anzahl von Kontaktflächen benötigt, so dass eine relativ große Chipfläche für die Kontaktierung erforderlich ist.

DE 42 28 274 A1 offenbart ein Verfahren zum Kontaktieren eines optoelektronischen Bauelements aus einem weitgehend starren Halbleitermaterial. In einem Ausführungsbeispiel ist das Bauelement eine Leuchtdiode aus Galliumarsenid. Das Bauelement ist auf einem Trägerkörper befestigt, bspw. verlötet oder verklebt. Anstelle von bekannten Bonddrähten schlägt DE 42 28 274 A1 vor, über dem Trägerkörper und dem Bauelement eine Polyimidfolie anzuordnen, in die Kontaktlöcher eingebracht werden. Anschließend wird eine Metallschicht auf der Polyimidfolie abgelagert, wobei das Metall auch in die Kontaktlöcher eindringt und auf diese Weise das Bauelement und den Trägerkörper elektrisch verbindet. Die eingangs genannte US 5,353,195 beschreibt ein Verfahren zur Herstellung eines sogenannten Multi-Chipmoduls mit einem Substrat, das einen Vielzahl von Chips trägt. In einem Ausführungsbeispiel wird eine bei Bedarf flexible Struktur beidseitig mit Metallisierungsebenen versehen und es werden in die flexible Struktur Öffnungen eingebracht, in die später Halbleiterchips eingesetzt werden. Zuvor wird die flexible Struktur mit den Löchern und den Metallisierungsbahnen mit Hilfe einer Klebeschicht auf einer dielektrischen Basisschicht angeordnet. Die Basisschicht selbst liegt auf einem Haltekörper auf. Anschließend werden die Halbleiterchips in die Öffnungen der flexiblen Struktur eingesetzt und mit einem Vergussmaterial vergossen. Der resultierende Schichtenkörper wird dann von dem Haltekörper entfernt. In die nun zugängliche dielektrische Basisschicht werden Durchgangslöcher eingebracht, die bis auf Kontaktstellen an den Halbleiterchips und den Metallisierungsebenen der flexiblen Struktur heranreichen. Anschließend wird eine weitere Metallisierung aufgebracht, die in die Durchgangslöcher eindringt und somit die Halbleiterchips an den freigelegten Kontaktstellen kontaktiert. Ziel dieses bekannten Verfahrens ist es, die Anzahl der Verarbeitungsschritte bei der Herstellung der Metallisierungsebenen für die Energiezuführung und Masse in sogenannten HDI (High Density Interconnect)-Multi-Chipmodulen zu reduzieren.

US 2008/0036093 A1 beschreibt ein weiteres Verfahren zum Einbetten von integrierten Schaltungen in mehrlagige Leiterplatten. Auch in diesem Fall werden Metallisierungsebenen aufgebracht, die durch zuvor erzeugte Kontaktlöcher bis zu vordefinierten Kontaktstellen der integrierten Schaltkreise reichen. Eine weitere Folienkontaktierung eines Siliziumchips ist aus WO2005/048302 bekannt. Vor diesem Hintergrund ist es eine Aufgabe der vorliegenden Erfindung, ein Verfahren anzugeben, um konventionelle Halbleiterchips, die aus Silizium und/oder anderen weitgehend starren Halbleitermaterialien hergestellt sind, einfach und kostengünstig mit einem flexiblen Folienstück, insbesondere aus einem organischen Halbleitermaterial, zu kombinieren.

Nach einem Aspekt der Erfindung wird diese Aufgabe durch ein Verfahren gemäß Anspruch 1 gelöst.

Gemäß einem weiteren Aspekt wird ein Folienchip mit einer integrierten elektronischen Schaltung gemäß dem Oberbegriff von Anspruch 9 vorgeschlagen, wobei die strukturierte Schicht, die eine Anzahl von elektrisch leitfähigen Kontaktbahnen zwischen dem Halbleitersubstrat und dem Folienstück bildet, direkt auf zueinander planparallel ausgerichteten Oberflächen des Halbleitersubstrats und des flexiblen Folienstücks angeordnet ist, und wobei das Halbleitersubstrat und das Folienstück ohne Kontaktlöcher elektrisch miteinander verbunden sind.

Eine mit Hilfe von Lithografieprozessschritten erzeugte, strukturierte Schicht zeigt sich bei dem neuen Folienchip vor allem daran, dass die Strukturen der Schicht so filigran sind, dass sie sich nur mit Lithografieprozessschritten erzeugen lassen. Mit anderen Worten sind die lateralen Abmessungen der einzelnen Strukturelemente, etwa einer Leiterbahn oder einer Kontaktfläche, kleiner und filigraner als dies mit Dickschichtprozessschritten einschließlich bekannten Drucktechniken möglich ist. Das neue Verfahren verwendet die bekannten Lithografieprozessschritte nicht nur zum Herstellen der Schaltungsstrukturen in dem üblicherweise eher starren Halbleitersubstrat, sondern auch zum Herstellen der elektrischen Kontaktbahnen, die von dem eher starren Halbleitersubstrat zu dem im Vergleich dazu eher flexiblen Trägermaterial führen. Daher besitzt der neue Folienchip, der mit Hilfe des neuen Verfahrens hergestellt wird, eine gemeinsame, durchlaufende Kontaktierungsschicht über dem Halbleitersubstrat und dem flexiblen Folienstück. Aufgrund der Lithografieprozessschritte kann diese Kontaktierungsschicht wesentlich feiner strukturiert werden als dies mit bekannten Drucktechniken möglich ist. Infolgedessen ist es möglich, auf vergleichsweise große Kontaktflächen an dem Halbleitersubstrat zu verzichten. Die Herstellung von elektrisch leitfähigen Verbindungen zwischen den integrierten Schaltungsstrukturen in dem Halbleitersubstrat und dem flexiblen Folienstück ist mit dem neuen Verfahren sehr platzsparend möglich.

Darüber hinaus besitzen das neue Verfahren und der darauf basierende Folienchip den Vorteil, dass die elektrisch leitfähigen Kontaktbahnen zwischen dem Halbleitersubstrat und dem flexiblen Folienstück erst erzeugt werden, nachdem das Halbleitersubstrat und das Folienstück bereits relativ zueinander angeordnet wurden. Infolgedessen ist das Verfahren relativ unempfindlich gegenüber Toleranzen beim Platzieren des Halbleitersubstrats relativ zu dem Folienstück. Die elektrisch leitfähigen Kontaktbahnen verbinden das Halbleitersubstrat und das Folienstück so, wie diese tatsächlich zueinander positioniert sind. Daher lässt sich das neue Verfahren relativ einfach und kostengünstig realisieren, zumal die Lithografieprozessschritte für die Erzeugung der Schaltungsstrukturen ohnehin benötigt werden und bewährt sind.

In bevorzugten Ausführungsbeispielen besitzt das Halbleitersubstrat eine Schichtdicke von weniger als 50 µm, vorzugsweise eine Schichtdicke von weniger als 20 µm, das heißt, das Halbleitersubstrat bildet einen sehr dünnen Halbleiterchip mit einer gewissen Eigenflexibilität. Ein derartig dünner Chip lässt sich vorteilhaft in eine dünne Folie mit einer Dicke von 0,5mm und weniger laminieren, wie dies weiter unten anhand eines bevorzugten Ausführungsbeispiels ausführlicher dargestellt ist.

In jedem Fall kann die zur Verfügung stehende Chipfläche des Halbleitersubstrats optimal für die Erzeugung der Schaltungsstrukturen ausgenutzt werden, da auf relativ große Kontaktflächen an dem Halbleitersubstrat verzichtet werden kann. Es ist natürlich trotzdem möglich, etwas vergrößerte Testflächen auf dem Halbleitersubstrat anzuordnen, beispielsweise in jeder Leiterbahn, um eine elektronische Prüfung der integrierten Schaltungsstrukturen zu ermöglichen, bevor das Halbleitersubstrat mit dem flexiblen Folienstück kombiniert wird. Diese Testflächen können jedoch kleiner sein als herkömmliche Kontaktpads. In bevorzugten Ausführungsbeispielen werden die Schaltungsstrukturen in dem Halbleitersubstrat ohne spezielle und - bezogen auf die lateralen Abmessungen der Schaltungsstrukturen - große Kontaktflächen oder Kontaktpads realisiert, um die zur Verfügung stehende Chipfläche optimal zu nutzen. Wie nachfolgend anhand bevorzugter Ausführungsbeispiele erläutert ist, können die integrierten Schaltungsstrukturen sehr gut über große Kontaktflächen am flexiblen Folienstück auf einfache und kostengünstige Weise getestet werden.

Die Erzeugung der Schaltungsstrukturen in dem Halbleitersubstrat erfolgt vorzugsweise, bevor das Halbleitersubstrat mit dem flexiblen Folienstück kombiniert wird. Prinzipiell könnten die Schaltungsstrukturen jedoch auch ganz oder teilweise erzeugt werden, nachdem das Halbleitersubstrat mit dem Folienstück kombiniert wurde. Daher ist die Reihenfolge der oben angegebenen Verfahrensschritte in Bezug auf die Erzeugung der Schaltungsstrukturen nicht zwingend.

Gemäß der Erfindung weist das Halbleitersubstrat eine erste Substratoberfläche auf und das flexible Folienstück weist eine erste Folienstückoberfläche auf, wobei die erste Substratoberfläche und die erste Folienstückoberfläche planparallel ausgerichtet werden.

In dieser Realisierung liegen die erste Substratoberfläche und die erste Folienstückoberfläche auf gleicher Höhe und parallel zueinander. Infolgedessen kann die gemeinsame, durchlaufende Kontaktierungsschicht einfacher hergestellt werden. Außerdem kann die Kontaktierungsschicht gleichmäßiger und dünner realisiert werden als in einer alternativenRealisierung, in der die Kontaktierungsschicht Höhenunterschiede zwischen dem Halbleitersubstrat und der Folienstückoberfläche ausgleichen muss.

Ferner werden die erste Substratoberfläche und die erste Folienstückoberfläche gemeinsam auf einem ebenen Haltekörper angeordnet, um die erste Substratoberfläche und die erste Folienstückoberfläche planparallel auszurichten.

In dieser Realisierung liegt die Kombination aus Halbleitersubstrat und erstem Folienstück auf einem vorzugsweise starren Haltekörper, während die strukturierte Schicht mit den elektrisch leitfähigen Kontaktbahnen erzeugt wird. In bevorzugten Ausführungsbeispielen ist der Haltekörper ein starres Halbleitersubstrat, etwa ein Substratwafer. Die Ausgestaltung ermöglicht eine einfache Integration in den Prozessablauf, der sich bei der Herstellung von integrierten Schaltungen mit Lithografieprozessschritten bewährt hat. Außerdem kann die planparallele Ausrichtung von Substratoberfläche und Folienstückoberfläche während der nachfolgenden Lithografieprozessschritte einfach und mit hoher Genauigkeit erreicht werden.

Des Weiteren weist das Halbleitersubstrat eine zweite Substratoberfläche auf, die in etwa parallel zu der ersten Substratoberfläche liegt, und das flexible Folienstück weist eine zweite Folienstückoberfläche auf, die in etwa parallel zu der ersten Folienstückoberfläche liegt, wobei die zweite Substratoberfläche und die zweite Folienstückoberfläche mit einem Vergussmaterial zu einem kombinierten Folienchip vergossen werden. In einer besonders bevorzugten Variante dieser Ausgestaltung ist das Vergussmaterial ein Polymermaterial.

In dieser Realisierung werden das Halbleitersubstrat und das Folienstück nicht nur mit elektrisch leitfähigen Kontaktbahnen verbunden, sondern sie werden auch mechanisch zu einem einzigen Bauteil zusammengefügt. Man erhält so einen Folienchip, der einen Kern aus dem weitgehend starren Halbleitermaterial und einen zumindest teilweise umlaufenden Folienrand aus einem flexiblen Material besitzt. Die Realisierung besitzt den Vorteil, dass die mit Hilfe der Lithografieprozessschritte erzeugten Kontaktbahnen zwischen dem Halbleitersubstrat und dem Folienstück stabilisiert und gegen Beschädigungen infolge einer Relativbewegung von Halbleitersubstrat und Folienstück geschützt werden. Außerdem kann der neue Folienchip als integriertes Bauteil sehr einfach mit anderen Bauteilen zu einer komplexen Schaltung kombiniert werden, wobei eine Kontaktierung des Folienchips selbst allein an dem flexiblen Rand und vor allem abseits des Halbleitersubstrats erfolgen kann.

Weiterhin werden das Halbleitersubstrat und das Folienstück zusammen mit dem Vergussmaterial von dem gemeinsamen Haltekörper gelöst, um die elektrisch leitfähige Schicht über der ersten Substratoberfläche und der ersten Folienstückoberfläche zu erzeugen.

Folglich dient der Haltekörper (zumindest zunächst) nur dazu, die Substratoberfläche und die Folienstückoberfläche möglichst planparallel auszurichten. Dies ist sehr einfach, indem man das Halbleitersubstrat und das Folienstück mit ihren jeweiligen Oberflächen auf dem ebenen Haltekörper ablegt. Dann werden die elektrisch leitfähigen Kontaktbahnen im wesentlichen direkt auf den zueinander ausgerichteten Oberfläche angeordnet. Dazu ist es erforderlich, einen direkten Zugang zu den beiden Oberflächen zu ermöglichen, was sehr einfach erreicht werden, indem man den Folienchip von dem gemeinsamen Haltekörper löst und beispielsweise umgedreht auf einem zweiten Haltekörper (oder auf demselben Haltekörper) wieder ablegt. Diese Realisierung ermöglicht es, das Halbleitersubstrat und das Folienstück ohne Kontaktlöcher elektrisch miteinander zu verbinden. Infolgedessen ermöglicht diese Ausgestaltung einen sehr dünnen, weitgehend homogenen und stabilen Schichtaufbau.

In einer bevorzugten Ausgestaltung wird ein weiteres flexibles Folienstück mit einer dritten Flächenausdehnung bereitgestellt, die wesentlich größer ist als die zweite Flächenausdehnung, wobei der Folienchip an dem weiteren Folienstück befestigt wird, und wobei die strukturierte Schicht mit weiteren Leiterbahnen kontaktiert wird, die auf dem weiteren flexiblen Folienstück ausgebildet sind.

In dieser Ausgestaltung wird der Folienchip mit einem weiteren folienartigen Folienstück kombiniert. In bevorzugten Ausführungsbeispielen ist das weitere Folienstück eine Polymerfolie, auf der elektronische Bauelemente angeordnet sind, die mit Hilfe von Dickschichtprozessschritten hergestellt wurden oder werden. Diese Ausgestaltung profitiert von den grundlegenden Vorteilen des neuen Verfahrens in besonderem Maße, da sie eine sehr einfache Kombination eines relativ kleinen, hochintegrierten Halbleiterchips mit einem großflächigen organischen Halbleitermaterial ermöglicht. Mit dieser Ausgestaltung lässt sich bspw. ein großflächiges Display mit organischen Leuchtdioden (OLEDs) und einer integrierten Ansteuer- und Treiberschaltung auf sehr einfache und kostengünstige Weise realisieren. Besonders bevorzugt ist es, wenn der neue Folienchip in die große Polymerfolie einlaminiert wird, wie dies weiter unten anhand eines bevorzugten Ausführungsbeispiels dargestellt ist.

In einer weiteren Ausgestaltung werden die weiteren Leiterbahnen mit Hilfe von Dickschichtprozessschritten auf dem weiteren Folienstück erzeugt.

Wie bereits zuvor angedeutet, ermöglicht diese Ausgestaltung eine optimale Kombination der komplementären Eigenschaften von organischen und herkömmlichen Halbleiterschaltungen. Die prinzipbedingten Unterschiede zwischen den beiden Technologien, die sich insbesondere in Bezug auf die lateralen Abmessungen der jeweiligen Strukturen bemerkbar machen, können mit Hilfe des neuen Verfahrens auf sehr einfache und elegante Weise überwunden werden, indem man relativ große Kontaktflächen (bezogen auf die lateralen Abmessungen der Schaltungsstrukturen in dem Halbleitersubstrat) nur im Bereich des ersten Folienstücks anordnet und von dort alle weiteren Kontaktierungen zu dem weiteren Folienstück führt.

In einer weiteren Ausgestaltung bildet die strukturierte Schicht fächerartige Kontaktbahnen, die von dem Halbleitersubstrat radial nach außen verlaufen und sich radial von innen nach außen aufweiten. Alternativ oder ergänzend können im Bereich des ersten Folienstücks Kontaktflächen angeordnet sein, die speziell zum elektrischen Anschluss von Leiterbahnen in Dickschichttechnik und/oder zum elektrischen Anschluss von lötbaren Kontakten ausgebildet sind.

Diese Ausgestaltungen ermöglichen einen sehr einfachen und kostengünstigen Anschluss von "großen" Leiterbahnstrukturen an die filigranen Schaltungsstrukturen in dem Halbleitersubstrat, ohne die wertvolle Chipfläche in dem Halbleitersubstrat zu vergeuden. Selbst wenn der neue Folienchip nicht mit einer großflächigen organischen Elektronik kombiniert wird, trägt diese Ausgestaltung zu einem kostengünstigen und vielfältig einsetzbaren Halbleiterchip bei. Eine strukturierte Schicht mit fächerartig ausgebildeten Kontaktbahnen besitzt gegenüber speziellen abgegrenzten Kontaktflächen den Vorteil von kleineren Übergangswiderständen.

In einer weiteren Ausgestaltung ist das erste flexible Folienstück eine Polymerfolie.

Diese Ausgestaltung ermöglicht eine kostengünstige und vielseitig verwendbare Realisierung des neuen Folienchips, und sie erleichtert die Integration des neuen Folienchips in eine großflächige Folie mit organischen Halbleiterelementen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1-3: Zwischenprodukte beim Herstellen einer integrierten Schaltung nach einem Verfahren, das nicht Gegenstand der beanspruchten Erfindung ist,
- Fig. 4 und 5: Zwischenprodukte beim Herstellen einer integrierten Schaltung in einem Ausführungsbeispiel des neuen Verfahrens,
- Fig. 6: einen Folienchip, der mit dem Verfahren gemäß Fig. 1-3 hergestellt und in eine großflächige Polymerfolie integriert wurde,
- Fig. 7: ein Ausführungsbeispiel eines Folienchips, der nach dem neuen Verfahren hergestellt wurde, in einer Draufsicht, und
- Fig. 8: ein weiteres Ausführungsbeispiel des neuen Folienchips.

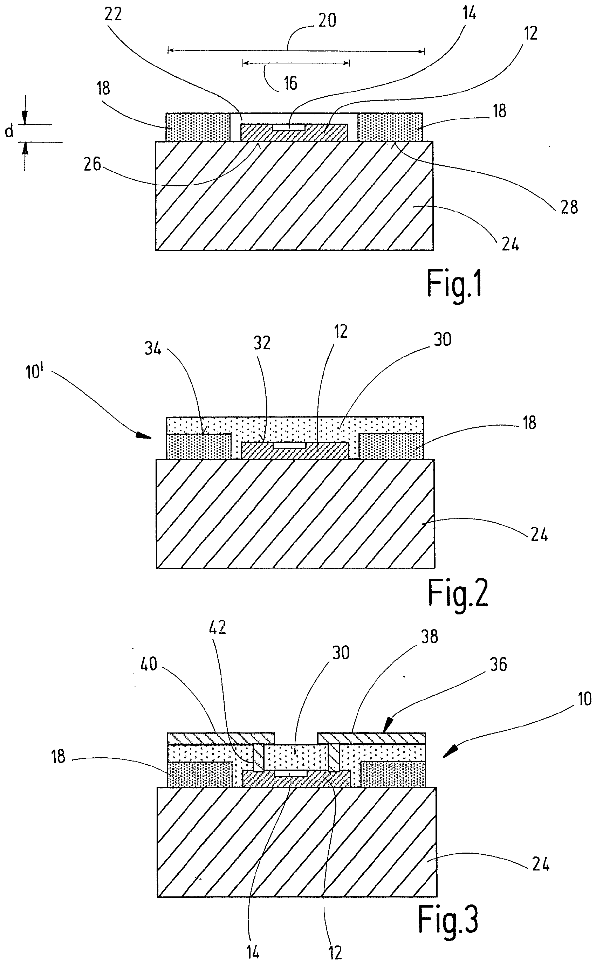

In den Figuren 1 bis 3 ist ein Folienchip in seiner Gesamtheit mit der Bezugsziffer 10 bezeichnet. Die Figuren 1 bis 3 zeigen einzelne Verfahrensschritte zum Herstellen des Folienchips 10.

In Fig. 1 ist ein Halbleitersubstrat mit der Bezugsziffer 12 bezeichnet. Das Halbleitersubstrat besitzt hier bereits eine integrierte Schaltungsstruktur, die schematisch bei der Bezugsziffer 14 angedeutet ist. Die Darstellung ist nicht maßstäblich. In einem Ausführungsbeispiel ist die Schaltungsstruktur 14 eine komplexe Schaltungsstruktur, die einen Ansteuer- und Treiberschaltkreis für ein großflächiges Display bildet. Die Schaltungsstruktur 14 kann jedoch auch für andere Aufgaben ausgebildet sein.

Wie den Fachleuten auf diesem Gebiet bekannt ist, kann die Schaltungsstruktur 14 eine Vielzahl von Transistoren beinhalten, die zusammen und/oder mit weiteren integrierten Bauelementen die Funktion der Schaltungsstruktur bestimmen. Die Schaltungsstruktur 14 wurde in diesem Ausführungsbeispiel in vorhergehenden Prozessschritten, die hier der Einfachheit halber nicht dargestellt sind, in dem Halbleitersubstrat erzeugt. Typischerweise beinhalten diese Prozessschritte die Erzeugung von Maskenstrukturen auf der Oberfläche des Halbleitersubstrats mit Hilfe von Belichtungs- und Ätzprozessen sowie das Einbringen und/oder Ablagern von Fremdmaterialien an der Oberfläche des Halbleitersubstrat durch die Maskenstrukturen hindurch. In der Regel wird ein solches Halbleitersubstrat mit einer integrierten Schaltungsstruktur als Halbleiterchip bezeichnet. Der Halbleiterchip ist hier in einem an sich starren Halbleitermaterial realisiert, insbesondere Silizium. Im Grunde ist das Halbleitersubstrat 12 mit der integrierten Schaltungsstruktur 14 ein "nackter" Halbleiterchip, der bei konventionellen Verfahren in ein starres Chipgehäuse aus Kunststoff eingegossen würde oder bspw. in Flip-Chip-Technologie auf einen Bauteilträger montiert würde. Nach dem neuen Verfahren wird ein Halbleiterchip 12 in der nachfolgend beschriebenen Weise mit einem flexiblen Trägermaterial zu dem Folienchip 10 kombiniert.

Das Halbleitersubstrat 12 besitzt eine erste Flächenausdehnung 16, die bspw. eine quadratische Flächenausdehnung mit einer Kantenlänge von 2 mm sein kann. In den bevorzugten Ausführungsbeispielen ist die Chipdicke d senkrecht zur Flächenausdehnung 16 kleiner als 50 µm und insbesondere im Bereich von 20 µm. Derartig dünne Halbleiterchips werden in den bevorzugten Ausführungsbeispielen mit einem Verfahren hergestellt, das in WO 2007/104443 beschrieben ist. Der Offenbarungsgehalt dieser Druckschrift ist hier durch Bezugnahme vollständig aufgenommen.

Das Halbleitersubstrat bzw. der Halbleiterchip 12 wird hier mit einem flexiblen Folienstück 18 kombiniert. Das flexible Folienstück 18 ist in den bevorzugten Ausführungsbeispielen eine Polymerfolie mit einer Flächenausdehnung 20, die etwas größer ist als die Flächenausdehnung 16 des Halbleitersubstrats 12. Bevorzugt liegt die Kantenlänge der Flächenausdehnung 20 in einer Größenordnung zwischen 5 mm und 20 mm. Die Dicke der Folie senkrecht zu ihrer Flächenausdehnung ist in bevorzugten Ausführungsbeispielen kleiner als 0,5 mm und liegt insbesondere im Bereich von etwa 20 µm bis etwa 100 µm. Die Folie 18 besitzt eine Ausnehmung 22, die eine sackartige Vertiefung (hier nicht dargestellt) oder eine Durchgangsöffnung (wie dargestellt) sein kann. Der Innendurchmesser der Ausnehmung 22 ist geringfügig größer als der entsprechende Außendurchmesser des Halbleitersubstrats 12, so dass das Halbleitersubstrat 12 in der Ausnehmung 22 angeordnet werden kann.

In Fig. 1 sind das Halbleitersubstrat 12 und die Folie 18 gemeinsam auf einem ebenen Haltekörper 24 angeordnet. Das Halbleitersubstrat besitzt eine erste Substratoberfläche 26, die plan auf der ebenen Oberseite des Haltekörpers 24 aufliegt. Die Folie 18 umgibt das Halbleitersubstrat 12 in diesem Fall konzentrisch und liegt mit ihrer Folienstückoberfläche 28 ebenfalls plan auf dem Haltekörper 24 auf. Infolgedessen sind die Substratoberfläche 26 und die Folienstückoberfläche 28 planparallel zueinander ausgerichtet. In einigen Ausführungsbeispielen dient der Haltekörper 24 allein zum Ausrichten und Halten des Halbleitersubstrats 12 und der Folie 18 bei der Herstellung des neuen Folienchips, d.h. der Haltekörper 24 wird am Ende des Herstellungsprozesses entfernt. In anderen Ausführungsbeispielen kann der Haltekörper 24 als "Transportträger" dienen, auf dem der Folienchip vom Hersteller zum Kunden transportiert wird.

Gemäß Fig. 2 werden das Halbleitersubstrat 12 und die Folie 18 nun mit einem Vergussmaterial 30 zu einem Folienchip 10' vergossen. In den bevorzugten Ausführungsbeispielen besteht das Vergussmaterial 30 ebenfalls aus einem Polymermaterial. Wie man anhand Fig. 2 leicht erkennen kann, legt sich das Vergussmaterial 30 hier von oben auf das Halbleitersubstrat 12 und die Folie 18, das heißt, das Vergussmaterial 30 haftet jeweils an derjenigen Oberfläche, die von dem Haltekörper 24 wegzeigt.

Gemäß Fig. 3 wird anschließend eine strukturierte Schicht 36 aus einem elektrisch leitfähigen Material über dem Halbleitersubstrat 12 und der Folie 18 und auf dem (ausgehärteten) Vergussmaterial 30 erzeugt. In bevorzugten Fällen ist das elektrisch leitfähige Material ein Metall, weshalb die Schicht 36 nachfolgend als Metallisierungsschicht bezeichnet wird. Die Metallisierungsschicht 36 bildet elektrisch leitfähige Kontaktbahnen 38, 40, die von dem Halbleitersubstrat 12 zu dem Folienstück 18 reichen.

In dem dargestellten Beispiel werden vor dem Erzeugen der Metallisierungsschicht 36 Durchgangslöcher 42 durch das Vergussmaterial 30 erzeugt. Zumindest einige der Durchgangslöcher 42 sind im Bereich des Halbleitersubstrats 12 angeordnet, um das Halbleitersubstrat 12 und die dort integrierte Schaltungsstruktur 14 zu kontaktieren. Die Durchgangslöcher 42 werden beim Erzeugen der Metallisierungsschicht mit dem elektrisch leitfähigen Material ausgefüllt, und sie bilden somit eine Kontaktbahn von der Metallisierungsschicht 36 zu dem darunter liegenden Halbleitersubstrat 12.

Die Metallisierungsschicht 36 wird hier mit Hilfe von Lithografieprozessschritten auf dem Folienchip 10' erzeugt. Die Prozessschritte beinhalten Belichtungs- und Ätzschritte sowie die Ablagerung oder Einbringung von Metall oder einem anderen elektrisch leitfähigen Material an exponierten, durch Ätzschritte freigelegten Oberflächenbereichen des Folienchips 10'. Es ist prinzipiell möglich, jedoch nicht in jedem Fall notwendig, Kontaktlöcher 42 auch im Bereich der Folie 18 anzuordnen, um eine elektrische Kontaktbahn durch das Vergussmaterial 30 hindurch zu der Folie 18 zu erzeugen.

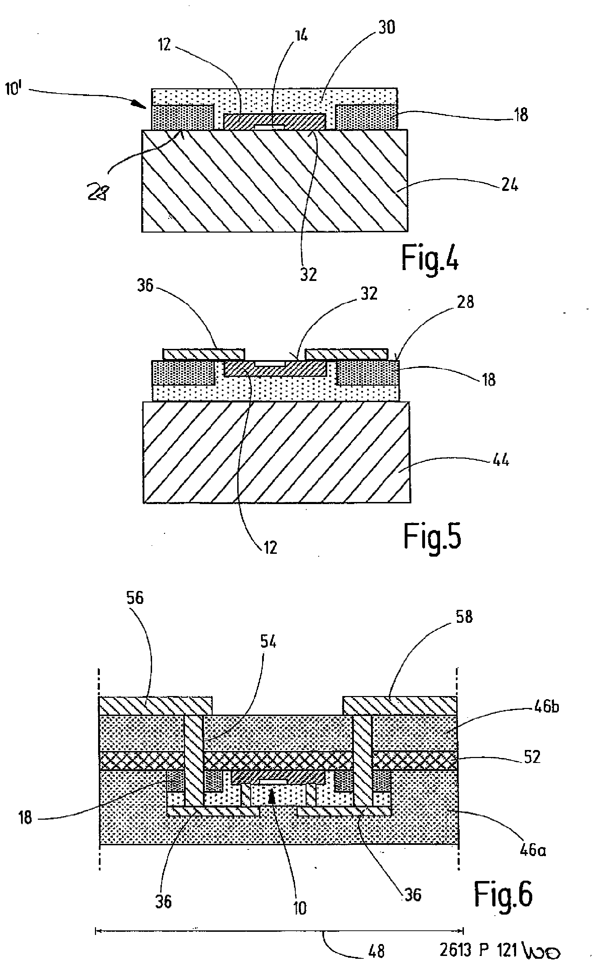

Nach dem Erzeugen der strukturierten Metallisierungsschicht 36, die eine Vielzahl von separaten Kontaktbahnen 38, 40 beinhaltet, steht der Folienchip 10 zur weiteren Verarbeitung zur Verfügung. Insbesondere kann er in eine großflächige Polymerfolie mit organischen Bauelementen integriert werden, wie dies weiter unten anhand Fig. 6 für ein bevorzugten Ausführungsbeispiel erläutert ist. Für eine derartige Weiterverarbeitung wird der Folienchip 10 nach dem Erzeugen der strukturierten Metallisierungsschicht 36 von dem Haltekörper 24 gelöst. Prinzipiell ist es möglich, den Folienchip 10' bereits vor dem Erzeugen der strukturierten Metallisierungsschicht 36 von dem Haltekörper 24 zu lösen, da der Haltekörper 24 für die Erzeugung der Metallisierungsschicht 36 nicht zwingend erforderlich ist. Er vereinfacht jedoch die Handhabung des Folienchips 10'.

Fig. 4 und 5 zeigen ein Ausführungsbeispiel des erfindungsgemäßen Verfahrens anhand von ausgewählten Zwischenprodukten. Gleiche Bezugszeichen bezeichnen dieselben Elemente wie zuvor.

Fig. 4 zeigt das Halbleitersubstrat 12 mit einer integrierten Schaltungsstruktur 14 und die Folie 18, die mit Hilfe des Vergussmaterials 30 zu dem Folienchip 10' kombiniert wurden. Im Unterschied zu dem Verfahren gemäß Fig. 1 bis 3 wurde das Halbleitersubstrat 12 hier jedoch mit seiner oberen Substratoberfläche 32 auf dem Haltekörper 24 angeordnet. Dies ist in Fig. 4 schematisch anhand der Schaltungsstruktur 14 angedeutet. Mit anderen Worten liegt der Halbleiterchip 12 in diesem Ausführungsbeispiel des Verfahrens genau umgedreht zu dem Ausführungsbeispiel gemäß Fig. 1 bis 3.

In diesem Ausführungsbeispiel wird der Folienchip 10' nach dem Vergießen mit dem Vergussmaterial 30 von dem Haltekörper 24 gelöst, so dass die planparallelen Oberflächen 32, 28 unmittelbar zugänglich sind. In dem bevorzugten Ausführungsbeispiel wird der Folienchip 10' allerdings erneut auf einem Haltekörper angeordnet, um die nachfolgende Erzeugung der strukturierten Metallisierungsschicht 36 zu erleichtern. Prinzipiell kann es sich um denselben Haltekörper 24 handeln, auf dem der Folienchip 10' lediglich um 180° gedreht abgelegt wird, oder es kann sich um einen weiteren Haltekörper 44 handeln, mit dessen Hilfe der Folienchip 10' von dem ersten Haltekörper 24 gelöst wird. Den einschlägigen Fachleuten auf diesem Gebiet sind hier verschiedene Alternativen zur Handhabung des (noch nicht fertig gestellten) Folienchips 10' bekannt.

Gemäß Fig. 5 wird die strukturierte Metallisierungsschicht 36 in diesem Ausführungsbeispiel direkt auf dem Halbleitersubstrat 12 und der Folie 18 erzeugt. Allerdings schließt dies nicht aus, dass hier noch Zwischenschichten vorhanden sein können, die aus prozesstechnischen Gründen oder aus anderen Gründen zwischen der Metallisierungsschicht 36 und dem Halbleitersubstrat 12 bzw. zwischen der Metallisierungsschicht 36 und der Folie 18 erforderlich oder unvermeidbar sind. Bspw. wird auf der Oberfläche eines Halbleitersubstrats mit einer integrierten Schaltungsstruktur häufig eine SiO₂-Schicht zur Passivierung und als Schutzschicht erzeugt. Diese muss allerdings an denjenigen Stellen, an denen die Metallisierungsschicht 36 die integrierte Schaltungsstruktur 14 elektrisch leitfähig kontaktiert, entfernt werden, was gemäß einem Aspekt der Erfindung mit Hilfe von Lithografieprozessschritten erfolgt. Im Unterschied zu dem Ausführungsbeispiel aus den Figuren 1 bis 3 ist die Metallisierungsschicht 36 hier jedoch über derjenigen Substratoberfläche 32 und derjenigen Folienstückoberfläche 28 angeordnet, die von dem Vergussmaterial 30 wegzeigen. Das Ausführungsbeispiel gemäß Fig. 4 und 5 ermöglicht eine Realisierung ohne Durchgangslöcher 42 im Folienchip. Allerdings muss der Folienchip 10' vor dem Erzeugen der Metallisierungsschicht 36 vom Haltekörper 24 gelöst werden.

Fig. 6 zeigt ein besonders bevorzugtes Ausführungsbeispiel des neuen Verfahrens, wobei der Folienchip 10 mit einem weiteren flexiblen Folienstück, insbesondere einer großflächigen Polymerfolie, kombiniert wird. Gleiche Bezugsziffern bezeichnen dieselben Elemente wie zuvor. Es versteht sich, dass anstelle des Folienchips 10, der nach dem Verfahren gemäß Fig. 1 bis 3 hergestellt wurde, auch der Folienchip nach dem Verfahren gemäß Fig. 4 und 5 mit einem großflächigen, weiteren, flexiblen Folienstück kombiniert werden kann.

In Fig. 6 ist das weitere flexible Folienstück eine Polymerfolie 46 mit einer Flächenausdehnung 48, die wesentlich größer ist als die erste und zweite Flächenausdehnung 16, 20. In einigen Ausführungsbeispielen liegt die Flächenausdehnung 48 in einer Größenordnung von 25 cm² und mehr, d.h. die Flächenausdehnung 48 besitzt beispielsweise eine Kantenlänge oder einen Durchmessen von 5 cm und mehr. Im Ausführungsbeispiel gemäß Fig. 6 wurde der Folienchip 10 mit der Metallisierungsschicht 36 auf einer Folie 46a angeordnet und mit einer weiteren Folie 46b und Klebstoff 52 laminiert. Hier bilden die beiden Folien 46a, 46b und der Klebstoff 52 das weitere flexible Folienstück mit der großen Flächenausdehnung 48.

Nach dem Einlaminieren des Folienchips 10 werden Durchgangslöcher 54 durch die Folie 46 mit Hilfe von Laserbohrungen oder anderen geeigneten Verfahren erzeugt. Die Durchgangslöcher 54 reichen bis zu der strukturierten Metallisierungsschicht 36. Außerdem werden weitere Kontaktbahnen 56, 58 aus einem elektrisch leitfähigen Material auf der Oberseite und/oder Unterseite der Folie 46 erzeugt. Die Kontaktbahnen 56, 58 werden durch die Durchgangslöcher 54 hindurch mit der Strukturierten Schicht 36 elektrisch leitfähig verbunden. Dies kann bspw. durch Auffüllen der Durchgangslöcher 54 mit einem elektrisch leitfähigen Material, insbesondere Metall, erfolgen. In den bevorzugten Ausführungsbeispielen werden die Kontaktbahnen 56, 58 mit Hilfe von Dickschichtprozessschritten erzeugt, insbesondere mit Hilfe von Drucktechniken. Die damit erreichbaren Strukturabmessungen sind wesentlich größer als die mit Lithografieprozessschritten erzeugbaren Strukturabmessungen. Allerdings genügt es nach dem neuen Verfahren, die äußeren Kontaktbahnen 56, 58 mit den einlaminierten Kontaktbahnen der strukturierten Schicht 36 leitfähig zu verbinden, wobei die inneren Kontaktbahnen der strukturierten Schicht 36 in vorteilhafter Weise für eine Größenanpassung sorgen.

Wie man anhand Fig. 6 erkennen kann, wird in den bevorzugten Ausführungsbeispielen des neuen Verfahrens ein neuer Folienchip 10 hergestellt, der einen Halbleiterchip 12 mit einer integrierten Schaltungsstruktur 14 und einen Folienrand 18 besitzt. Ein solcher Folienchip 10 kann auf sehr einfache und kostengünstige Weise mit weiteren Folien kombiniert und elektrisch leitfähig verbunden werden, wobei der erste Folienrand 18 relativ große Kontaktflächen bereitstellt, ohne die Chipfläche innerhalb des Halbleitersubstrats 12 nennenswert zu beeinträchtigen.

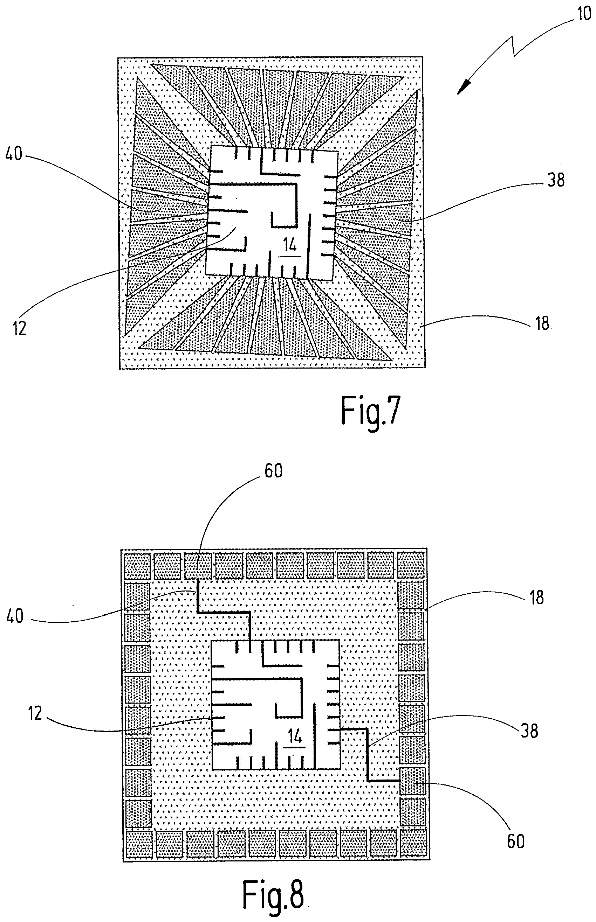

Fig. 7 zeigt eine schematische Darstellung eines Ausführungsbeispiels des neuen Folienchips 10 in einer Draufsicht. Gleiche Bezugsziffern bezeichnen dieselben Elemente wie zuvor.

Wie man anhand Fig. 7 erkennen kann, ist das neue Verfahren relativ robust gegenüber Toleranzen beim Positionieren des Halbleitersubstrats 12 relativ zu dem ersten Folienstück 18, da die Kontaktbahnen 38, 40 erst nach dem Positionieren von Halbleitersubstrat 12 und Folienstück 18 mit Hilfe der Lithografieprozessschritte erzeugt werden. Etwaige Positionstoleranzen können daher beim Erzeugen der strukturierten Schicht 36 mit den Kontaktbahnen 38, 40 berücksichtigt werden. Wie man anhand Fig. 7 außerdem erkennen kann, besitzt der Folienchip 10 in diesem Ausführungsbeispiel fächerartig ausgebildete Kontaktbahnen 38, 40, die sich radial von innen nach außen aufweiten. Auf diese Weise ermöglicht dieses Ausführungsbeispiel eine widerstandsarme Kontaktierung der filigranen Schaltungsstruktur 14 an relativ breiten Kontaktflächen.

Fig. 8 zeigt ein weiteres Ausführungsbeispiel eines Folienchips, der nach dem neuen Verfahren hergestellt wurde. In diesem Ausführungsbeispiel besitzt der Folienchip im Bereich der flexiblen Folie 18 Kontaktflächen 60, die hier rechteckig und insbesondere quadratisch ausgebildet sind. Die einzelnen Kontaktflächen 60 auf dem Folienrand 18 sind über filigrane Kontaktbahnen 38, 40 mit der Schaltungsstruktur 14 in dem Halbleitersubstrat 12 verbunden. Mit diesem Ausführungsbeispiel erhält man "konventionelle Bonding-Pads" 60, die nun aber auf dem flexiblen Folienrand 18 des neuen Folienchips angeordnet sind. Auch hier reduzieren die relativ großen Kontaktflächen die nutzbare Chipfläche in dem Halbleitersubstrat 12 nicht. Es ist denkbar, Kontaktflächen 60 nicht nur am äußeren Rand der flexiblen Folie 18, sondern im gesamten Flächenbereich um das Halbleitersubstrat 12 herum anzuordnen, wobei die entsprechenden Kontaktbahnen 38, 40 dann zwischen den einzelnen Kontaktflächen 60 hindurchgeführt werden müssen. Ein solches Ausführungsbeispiel ermöglicht es, sehr viele große Kontaktflächen bereitzustellen, was vor allem zum Herstellen von grafischen Displays von Vorteil ist.

In allen Ausführungsbeispielen der Erfindung besitzt das Halbleitersubstrat 12 keine oder nur eine sehr geringe Anzahl von konventionellen, relativ großen Kontaktflächen. Eine geringe Anzahl von konventionellen, großen Kontaktflächen kann zu Testzwecken auf dem Halbleitersubstrat angeordnet sein. Des Weiteren ist dieses Halbleitersubstrat mit einem flexiblen Folienstück, insbesondere einem Folienrand, kombiniert, auf dem relativ große Kontaktflächen ausgebildet sind. Eine elektrisch leitfähige, strukturierte Schicht, die Kontaktbahnen von dem Halbleitersubstrat zu den großen Kontaktflächen bereitstellt, wurde mit Hilfe von Lithografieprozessschritten auf dem neuen Folienchip erzeugt, um das Halbleitersubstrat und die dort integrierten Schaltungsstrukturen mit den Kontaktflächen auf dem Folienstück elektrisch leitfähig zu verbinden. Somit steht (nahezu) die gesamte Fläche des Halbleitersubstrats für die integrierten Schaltungsstrukturen zur Verfügung. Außerdem kann der neue Folienchip sehr einfach und kostengünstig mit organischen Halbleiterbauelementen verbunden werden, indem man vergleichsweise grobe Kontaktbahnen mit Dickschichtprozessschritten erzeugt. Die Schnittstelle zwischen dem Halbleitersubstrat und dem Folienrand ist vorteilhafterweise ausschließlich mit Lithografieprozessschritten hergestellt.

## Patentansprüche

1. Verfahren zum Herstellen einer integrierten Schaltung, mit den Schritten:
- Bereitstellen eines Halbleitersubstrats (12) mit einer ersten Flächenausdehnung (16), wobei das Halbleitersubstrat (12) eine erste Substratoberfläche (32) und eine zweite Substratoberfläche aufweist, die in etwa parallel zu der ersten Substratoberfläche (32) liegt,
- Erzeugen von Schaltungsstrukturen (14) in dem Halbleitersubstrat (12) mit Hilfe von Lithografieprozessschritten,
- Bereitstellen eines ersten flexiblen Folienstücks (18) mit einer zweiten Flächenausdehnung (20), die größer ist als die erste Flächenausdehnung (16), und mit einer Ausnehmung (22) in der zweiten Flächenausdehnung, wobei das flexible Folienstück (18) eine erste Folienstückoberfläche (28) und eine zweite Folienstückoberfläche aufweist, die in etwa parallel zu der ersten Folienstückoberfläche (28) liegt,
- Anordnen des Halbleitersubstrats (12) und des ersten flexiblen Folienstücks (18) auf einem ebenen Haltekörper (24), wobei das Halbleitersubstrat (12) in der Ausnehmung (22) angeordnet wird,
- Vergießen der zweiten Substratoberfläche und der zweiten Folienstückoberfläche mit einem Vergussmaterial (30) zu einem kombinierten Folienchip (10),
- Lösen des Folienchips (10) von dem gemeinsam Haltekörper (24), und
- Erzeugen einer strukturierten Schicht (36) aus einem elektrisch leitfähigen Material über dem Halbleitersubstrat (12) und dem ersten flexiblen Folienstück (18) mit Hilfe von Lithografieprozessschritten,
wobei sich die strukturierte Schicht (36) von dem Halbleitersubstrat (12) bis zu dem ersten flexiblen Folienstück (18) erstreckt und eine Anzahl von elektrisch leitfähigen Kontaktbahnen (36) zwischen dem Halbleitersubstrat (12) und dem ersten Folienstück (18) bildet,
**dadurch gekennzeichnet, dass** die erste Substratoberfläche (32) und die erste Folienstückoberfläche (28) planparallel auf dem ebenen Haltekörper (24) angeordnet werden, um die erste Substratoberfläche (32) und die erste Folienstückoberfläche (28) planparallel auszurichten,
wobei der kombinierte Folienchip (10) von dem Haltekörper (24) gelöst wird, so dass die planparallelen Oberflächen (28, 32) des Halbleitersubstrats (12) und des ersten flexiblen Folienstücks (18) unmittelbar zugänglich sind, und wobei die strukturierte Schicht (36) direkt auf den zueinander ausgerichteten Oberflächen (28, 32) angeordnet wird, wobei das Halbleitersubstrat (12) und das Folienstück (18) ohne Kontaktlöcher elektrisch miteinander verbunden werden.

2. Verfahren nach Anspruch 1, wobei das Vergussmaterial (30) ein Polymermaterial ist.

3. Verfahren nach einem der Ansprüche 1 oder 2, wobei ein weiteres flexibles Folienstück (46) mit einer dritten Flächenausdehnung (48) bereitgestellt wird, die wesentlich größer ist als die zweite Flächenausdehnung (20), wobei der Folienchip (10) an dem weiteren Folienstück (46) befestigt wird, und wobei die strukturierte Schicht (36) mit weiteren Leiterbahnen (56, 58) kontaktiert wird, die auf dem weiteren flexiblen Folienstück (46) ausgebildet sind.

4. Verfahren nach Anspruch 3, wobei die weiteren Leiterbahnen (56, 58) mit Hilfe von Dickschichtprozessschritten auf dem weiteren Folienstück (46) erzeugt werden.

5. Verfahren nach Anspruch 3 oder 4, wobei der kombinierte Folienchip (10) einen Kern aus einem weitgehend starren Halbleitermaterial und einen zumindest teilweise umlaufenden Folienrand aus dem flexiblen Folienstück (18) besitzt, wobei auf dem Folienrand Kontaktflächen (60) angeordnet werden, die bezogen auf die lateralen Abmessungen der Schaltungsstrukturen (14) in dem Halbleitersubstrat (12) groß sind, und wobei von diesen Kontaktflächen (60) alle weiteren Kontaktierungen zu dem weiteren Folienstück (46) geführt werden.

6. Verfahren nach einem der Ansprüche 1 bis 5, wobei die strukturierte Schicht (36) fächerartige Kontaktbahnen (38, 40) bildet, die von dem Halbleitersubstrat (12) radial nach außen verlaufen und sich radial von innen nach außen aufweiten.

7. Verfahren nach einem der Ansprüche 1 bis 6, wobei die Schaltungsstrukturen (14) in dem Halbleitersubtrat (12) ohne spezielle, bezogen auf die lateralen Abmessungen der Schaltungsstrukturen (14) große Kontaktflächen oder Kontaktpads realisiert werden.

8. Verfahren nach einem der Ansprüche 1 bis 7, wobei das erste flexible Folienstück (18) eine Polymerfolie ist.

9. Folienchip mit einer integrierten elektronischen Schaltung (14), mit einem Halbleitersubstrat (12) mit einer ersten Flächenausdehnung (16), in dem Schaltungsstrukturen (14) mit Hilfe von Lithografieprozessschritten erzeugt sind, mit einem flexiblen Folienstück (18) mit einer zweiten Flächenausdehnung (20), die größer ist als die erste Flächenausdehnung (16), und mit einer Ausnehmung (22) in der zweiten Flächenausdehnung (20), wobei das Halbleitersubstrat (12) in der Ausnehmung (22) angeordnet ist, und mit einer strukturierten Schicht (36) aus einem elektrisch leitfähigen Material über dem Halbleitersubstrat (12) und dem Folienstück (18), die sich von dem Halbleitersubstrat (12) bis zu dem Folienstück (18) erstreckt und eine Anzahl von elektrisch leitfähigen Kontaktbahnen (38, 40) zwischen dem Halbleitersubstrat (12) und dem Folienstück (18) bildet, wobei die strukturierte Schicht (36) mit Hilfe von Lithografieprozessschritten erzeugt ist, **dadurch gekennzeichnet, dass** die strukturierte Schicht (36) direkt auf zueinander planparallel ausgerichteten Oberflächen (28, 32) des Halbleitersubstrats (12) und des flexiblen Folienstücks (18) angeordnet ist, wobei das Halbleitersubstrat (12) und das Folienstück (18) ohne Kontaktlöcher elektrisch miteinander verbunden sind.

## Claims

1. A method for producing an integrated circuit, comprising the steps of
- providing a semiconductor substrate (12) having a first lateral dimension (16), said semiconductor substrate (12) comprising a first substrate surface (32) and a second substrate surface arranged substantially parallel to the first substrate surface (32),
- producing circuit structures (14) in the semiconductor substrate (12) using lithography process steps,
- providing a first flexible film piece (18) having a second lateral dimension (20), which is greater than the first lateral dimension (16), and having a recess (22) in the second lateral dimension, wherein the flexible film piece (18) has a first film piece surface (28) and a second film piece surface (34) arranged substantially parallel to the first film piece surface (28),
- arranging the semiconductor substrate (12) and the first flexible film piece (18) on a planar holding body (24), the semiconductor substrate (12) being arranged in the recess (22),
- encapsulating the second substrate surface and the second film piece surface with a potting material (30) to form a combined film chip (10),
- detaching the film chip (10) from the common holding body (24) and
- producing a patterned layer (36) of an electrically conductive material above the semiconductor substrate (12) and the first flexible film piece (18) using lithography process steps,
wherein the patterned layer (36) extends from the semiconductor substrate (12) up to the first flexible film piece (18) and forms a number of electrically conductive contact tracks (36) between the semiconductor substrate (12) and the first film piece (18),
**characterized in that** the first substrate surface (32) and the first film piece surface (28) are arranged in plane-parallel fashion on the common holding body (24) in order to orient the first substrate surface (32) and the first film piece surface (28) in plane-parallel fashion
wherein the combined film chip (10) is detached from the holding body (24) so that the plane-parallel surfaces (28, 32) of the semiconductor substrate (12) and the first flexible film piece (18) are directly accessible, and
wherein the patterned layer (36) is directly arranged on the mutually aligned surfaces (28, 32), with the semiconductor substrate (12) and the film piece (18) being electrically connected to one another without contact holes.

2. The method of claim 1, wherein the potting material (30) is a polymer material.

3. The method of any of claims 1 or 2, wherein a further flexible film piece (46) is provided, said further flexible film piece having a third lateral dimension (48) which is significantly greater than the second lateral dimension (20), wherein the film chip (10) is fixed to the further film piece (46), and wherein the patterned layer (36) is contact-connected to further conductor tracks (56, 58) formed on the further flexible film piece (46).

4. The method of claim 3, wherein the further conductor tracks (56, 58) are produced using thick-film process steps on the further film piece (46).

5. The method of any of claims 3 or 4, wherein the combined film chip (10) has a core composed of a substantially rigid semiconductor material and an at least partly circumferential film edge composed of the flexible film piece (18), with contact areas (60) being arranged on the film edge, said contact areas being large relative to the lateral dimensions of the circuit structures (14) in the semiconductor substrate (12), and wherein any further contact-connections to the further film piece (46) are led to said contact areas (60).

6. The method of any of claims 1 to 5, wherein the patterned layer (36) forms fan-like contact tracks (38, 40) which run radially outward from the semiconductor substrate (12) and expand from the inner portion radially outward.

7. The method of any of claims 1 to 6, wherein the circuit structures (14) in the semiconductor substrate (12) are implemented without any large contact areas or contact pads with respect to the lateral dimensions of the circuit structures (14).

8. The method of any of claims 1 to 7, wherein the first flexible film piece (18) is a polymer film.

9. A film chip comprising an integrated electronic circuit (14), comprising a semiconductor substrate (12) having a first lateral dimension (16), in which circuit structures (14) have been produced using lithography process steps, comprising a flexible film piece (18) having a second lateral dimension (20), which is greater than the first lateral dimension (16), and having a recess (22) in the second lateral dimension (20), wherein the semiconductor substrate (12) is arranged in the recess (22), and comprising a patterned layer (36) composed of an electrically conductive material above the semiconductor substrate (12) and the film piece (18), which layer extends from the semiconductor substrate (12) up to the film piece (18) and forms a number of electrically conductive contact tracks (38, 40) between the semiconductor substrate (12) and the film piece (18), wherein the patterned layer (36) is produced using lithography process steps, **characterized in that** the patterned layer (36) is directly arranged on surfaces (28, 32) of the semiconductor substrate (12) and the flexible film piece (18), which surfaces are mutually aligned in plane-parallel fashion, with the semiconductor substrate (12) and the film piece (18) being electrically connected to one another without contact holes.

## Revendications

1. Procédé de fabrication d'un circuit intégré, le procédé comportant les étapes qui consistent à :
préparer un substrat semi-conducteur (12) présentant une première extension de surface (16), le substrat semi-conducteur (12) présentant une première surface de substrat (32) et une deuxième surface de substrat située essentiellement en parallèle à la première surface de substrat (32),
former des structures de circuit (14) dans le substrat semi-conducteur (12) à l'aide d'étapes de traitement par lithographie,
préparer un premier morceau (18) de feuille flexible présentant une deuxième extension de surface (20) plus grande que la première extension de surface (16) et une découpe (22) dans la deuxième extension de surface, le morceau flexible de feuille (18) présentant une première surface (28) de morceau de feuille et une deuxième surface de morceau de feuille située essentiellement en parallèle à la première surface (28) de morceau de feuille,
placer le substrat semi-conducteur (12) et le morceau flexible de feuille (18) sur un corps plan de maintien (24), le substrat semi-conducteur (12) étant disposé dans la découpe (22),
couler un matériau de coulée (30) sur la deuxième surface de substrat et la deuxième surface du morceau de feuille pour former une puce (10) en feuille combinée,
enlever la puce (10) en feuille du corps de maintien commun (24) et
former une couche structurée (36) en matériau électriquement conducteur au-dessus du substrat semi-conducteur (12) et du morceau flexible de feuille (18) à l'aide d'étapes de traitement par lithographie,
la couche structurée (36) s'étendant depuis le substrat semi-conducteur (12) jusqu'au morceau flexible de feuille (18) et formant plusieurs pistes électriquement conductrices de contact (36) entre le substrat semi-conducteur (12) et le premier morceau de feuille (18),
**caractérisé en ce que**
la première surface de substrat (32) et la première surface (28) de morceau de feuille sont disposées dans des plans parallèles sur le corps plan de maintien (24) de manière à orienter la première surface de substrat (32) et la première surface (28) de morceau de feuille dans des plans parallèles,
**en ce que** la puce (10) en feuille combinée est retirée du corps de maintien (24) de telle sorte que les surfaces (28, 32) situées dans des plans parallèles du substrat semi-conducteur (12) et du morceau flexible de feuille (18) soient directement accessibles,
**en ce que** la couche structurée (36) est disposée directement sur les surfaces (28, 32) alignées l'une sur l'autre et
**en ce que** le substrat semi-conducteur (12) et le morceau de feuille (18) sont reliés électriquement l'un à l'autre sans trous de contact.

2. Procédé selon la revendication 1, dans lequel le matériau de coulée (30) est un matériau polymère.

3. Procédé selon l'une des revendications 1 ou 2, dans lequel un autre morceau de feuille flexible (46) est préparé à une troisième extension de surface (48) beaucoup plus grande que la deuxième extension de surface (20), la puce en feuille (10) étant fixée sur l'autre morceau de feuille (46) et la couche structurée (36) étant mise en contact avec d'autres pistes conductrices (56, 58) formées sur l'autre morceau de feuille flexible (46).

4. Procédé selon la revendication 3, dans lequel les autres pistes conductrices (56, 58) sont formées sur l'autre morceau de feuille (46) à l'aide d'étapes de traitement en couche épaisse.

5. Procédé selon les revendications 3 ou 4, dans lequel la puce (10) en feuille combinée possède une âme constituée d'un matériau semi-conducteur largement rigide au moins en partie et par un bord en le morceau flexible de feuille (18), des surfaces de contact (60) plus grandes que les dimensions latérales des structures de circuit (14) du substrat semi-conducteur (12) étant disposées sur le bord en feuille, tous les autres contacts étant prolongés de ces surfaces de contact (60) jusqu'à l'autre morceau de feuille (46).

6. Procédé selon l'une des revendications 1 à 5, dans lequel la couche structurée (36) forme des pistes de contact (38, 40) en forme d'éventail qui s'étendent radialement vers l'extérieur depuis le substrat semi-conducteur (12) et qui s'évasent radialement de l'intérieur vers l'extérieur.

7. Procédé selon l'une des revendications 1 à 6, dans lequel les structures de circuit (14) sont réalisées dans le substrat semi-conducteur (12) sans surface de contact ou piste de contact particulière plus grande que les dimensions latérales des structures de circuit (14).

8. Procédé selon l'une des revendications 1 à 7, dans lequel le premier morceau de feuille flexible (18) est une feuille polymère.

9. Puce en feuille dotée d'un circuit électronique intégré (14), d'un substrat semi-conducteur (12) présentant une première extension de surface (16) dans lequel des structures de circuit (14) sont formées à l'aide d'étapes de traitement par lithographie, un morceau (18) de feuille flexible présentant une deuxième extension de surface (20) plus grande que la première extension de surface (16) et une découpe (22) ménagée dans la deuxième extension de surface (20), le substrat semi-conducteur (12) étant disposé dans la découpe (22), et une couche structurée (36) en matériau électriquement conducteur au-dessus du substrat semi-conducteur (12) et du morceau de feuille (18), qui s'étend depuis le substrat semi-conducteur (12) jusqu'au morceau de feuille (18) et forme plusieurs pistes électriquement conductrices de contact (38, 40) entre le substrat semi-conducteur (12) et le morceau de feuille (18), la couche structurée (36) étant formée à l'aide d'étapes de traitement par lithographie,
**caractérisée en ce que**
la surface structurée (36) est disposée directement sur des surfaces (28, 32) orientées dans des plans parallèles du substrat semi-conducteur (12) et du morceau flexible de feuille (18), le substrat semi-conducteur (12) et le morceau (18) de feuille étant raccordés électriquement l'un à l'autre sans trous de contact.
